# EUROPEAN PATENT APPLICATION

(11) **EP 2 533 296 A1**
(43) Date of publication of application: **12.12.2012**
(21) Application number: 11737072.6
(22) Date of filing: 27.01.2011
(51) Int. Cl.: H01L 31/04

(54) **PROCESS FOR PRODUCTION OF BACK-ELECTRODE-TYPE SOLAR CELL, BACK-ELECTRODE-TYPE SOLAR CELL, AND BACK-ELECTRODE-TYPE SOLAR CELL MODULE**

(30) Priority: 01.02.2010 JP 2010020029
(71) Applicant: Sharp Kabushiki Kaisha, Osaka-shi, Osaka 545-8522 (JP)
(72) Inventor: YOKOSAWA, Yuhji, Osaka 545-8522 (JP); FUNAKOSHI, Yasushi, Osaka 545-8522 (JP); OKAMOTO, Satoshi, Osaka 545-8522 (JP); KURAHASHI, Takahisa, Osaka 545-8522 (JP)
(74) Representative: Müller - Hoffmann & Partner
(86) International application number: PCT/JP2011/051555
(87) International publication number: WO 2011/093360

(57) **Abstract**

A method for producing a back electrode type solar cell (1, 16) including the steps of forming a light-receiving surface diffusion layer (6) and an anti-reflection film (7, 12) by applying, to a light-receiving surface of a silicon substrate (4), a solution (27) containing a compound containing an impurity identical in conductivity type to the silicon substrate (4), a titanium alkoxide, and an alcohol, followed by heat treatment, and forming a light-receiving surface passivation film (8) on the light-receiving surface of the silicon substrate (4) by heat treatment; a back electrode type solar cell (1, 16) including a light-receiving surface diffusion layer (6), and an anti-reflection film (7) on the light-receiving surface diffusion layer (6), made of titanium oxide containing an impurity identical in conductivity type to a silicon substrate (4); and a back electrode type solar cell module (35) including the back electrode type solar cells (1, 16).

## Description

### TECHNICAL FIELD

The present invention relates to a method for producing a back electrode type solar cell, a back electrode type solar cell, and a back electrode type solar cell module.

### BACKGROUND ART

Expectations for solar cells for directly converting sunlight energy into electrical energy as a next-generation source of energy are recently rapidly growing, particularly from the standpoint of global environmental issues. While there are various types of solar cells including those using compound semiconductors and those using organic materials, solar cells using silicon crystals are the current mainstream.

Solar cells that are most widely produced and on the market today have such a structure that an electrode is formed on a surface where sunlight enters (light-receiving surface), and an electrode is formed on a surface opposite to the light-receiving surface (back surface).

Where an electrode is formed on the light-receiving surface of a solar cell, sunlight is absorbed by the electrode, which reduces the amount of sunlight that enters the light-receiving surface of the solar cell by the amount of the area on which the electrode is formed. Thus, a back electrode type solar cell including an electrode formed solely on the back surface of the solar cell has been developed.

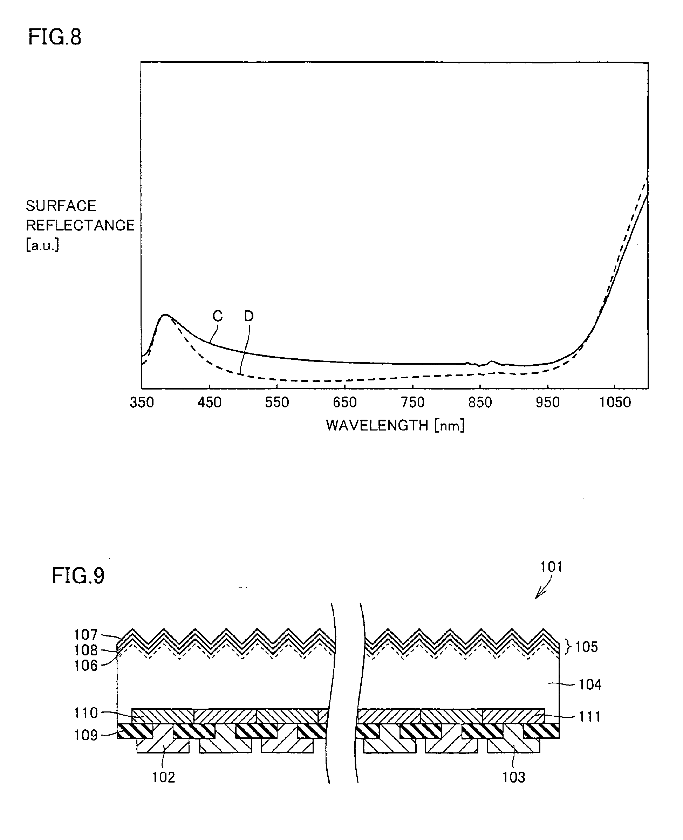

Fig. 9 shows a schematic cross-sectional view of the conventional back electrode type solar cell disclosed in PTL 1 (Japanese National Patent Publication No. 2008-532311).

A front surface-side n-type diffusion region 106 is formed on a light-receiving surface of conventional back electrode type solar cell 101 shown in Fig. 9, whereby an FSF (Front Surface Field) structure is formed. The light-receiving surface of back electrode type solar cell 101 has a concavo-convex shape 105, on which a dielectric passivation layer 108 containing silicon dioxide and an anti-reflection coating 107 containing silicon nitride are formed in this order from an n-type silicon wafer 104.

On a back surface of n-type silicon wafer 104, an n⁺ region 110 doped with an n-type impurity and a p⁺ region 111 doped with a p-type impurity are formed alternately, and an oxide layer 109 is formed on the back surface of n-type silicon wafer 104. Moreover, an n-type metal contact 102 is formed on n⁺ region 110, and a p-type metal contact 103 is formed on p⁺ region 111, of the back surface of n-type silicon wafer 104.

The structure on the light-receiving surface-side of n-type silicon wafer 104 is formed as follows. Concavo-convex shape 105 is formed by etching the surface of n-type silicon wafer 104 that will serve as the light-receiving surface, and then front surface-side n-type diffusion region 106 is formed by diffusing an n-type impurity. Dielectric passivation layer 108 containing silicon dioxide is next formed by high-temperature oxidation, and then anti-reflection coating 107 containing silicon nitride is formed by plasma enhanced chemical vapor deposition (PECVD).

The structure on the back surface-side of n-type silicon wafer 104 is formed as follows. On the back surface opposite to the surface that will serve as the light-receiving surface of n-type silicon wafer 104, n⁺ region 110 doped with an an-type impurity and p⁺ region 111 doped with a p-type impurity are formed, and then oxide layer 109 is formed on the back surface of n-type silicon wafer 104. Portions of oxide layer 109 are next removed for patterning, and n-type metal contact 102 and p-type metal contact 103 are formed on n⁺ region 110 and p⁺ region 111, respectively, that are exposed through oxide layer 109.

### CITATION LIST

### PATENT LITERATURE

PTL 1: Japanese National Patent Publication No. 2008-532311

### SUMMARY OF INVENTION

### TECHNICAL PROBLEM

However, in the method for producing back electrode type solar cell 101 described in PTL 1 above, concavo-convex shape 105 is formed on the light-receiving surface of n-type silicon wafer 104, front surface-side n-type diffusion region 106 is next formed, dielectric passivation layer 108 is then formed, and anti-reflection coating 107 is subsequently formed. Thus, due to such a great number of steps, the back electrode type solar cell could not be efficiently produced.

In view of the above-described circumstances, an object of the present invention is to provide a method for producing a back electrode type solar cell that allows efficient production with a reduced number of steps, a back electrode type solar cell, and a back electrode type solar cell module.

### SOLUTION TO PROBLEM

The present invention is directed to a method for producing a back electrode type solar cell including the steps of forming a light-receiving surface diffusion layer and an anti-reflection film by applying, to a light-receiving surface of a silicon substrate, a solution containing a compound containing an impurity identical in conductivity type to the silicon substrate, a titanium alkoxide, and an alcohol, followed by heat treatment, forming a light-receiving surface passivation film on the light-receiving surface of the silicon substrate by heat treatment, and forming an n-type electrode and a p-type electrode on a back surface of the silicon substrate opposite to the light-receiving surface.

In the method for producing a back electrode type solar cell according to the present invention, the light-receiving surface passivation film is preferably a silicon oxide film.

In the method for producing a back electrode type solar cell according to the present invention, the step of forming the light-receiving surface passivation film preferably includes the step of forming a back surface passivation film on the back surface of the silicon substrate.

In the method for producing a back electrode type solar cell according to the present invention, the light-receiving surface diffusion layer preferably has a sheet resistance of not less than 30 Ω/□ and not more than 100 Ω/□.

In the method for producing a back electrode type solar cell according to the present invention, the light-receiving surface passivation film preferably has a thickness not less than 30 nm and not more than 200 nm.

Moreover, the present invention is directed to a back electrode type solar cell including a light-receiving surface diffusion layer provided on a light-receiving surface of a silicon substrate, a light-receiving surface passivation film provided on the light-receiving surface diffusion layer, an anti-reflection film provided on the light-receiving surface passivation film, and an n-type electrode and a p-type electrode provided on a back surface opposite to the light-receiving surface of the silicon substrate, the light-receiving surface diffusion layer being identical in conductivity type to the silicon substrate and having an impurity concentration higher than that in the silicon substrate, and the anti-reflection film being a titanium oxide film containing an impurity identical in conductivity type to the silicon substrate.

Furthermore, the present invention is directed to a back electrode type solar cell including a light-receiving surface diffusion layer provided on a light-receiving surface of a silicon substrate, a light-receiving surface passivation film provided on the light-receiving surface diffusion layer, an anti-reflection film provided on a portion of the light-receiving surface passivation film, and an n-type electrode and a p-type electrode provided on a back surface opposite to the light-receiving surface of the silicon substrate, the light-receiving surface diffusion layer being identical in conductivity type to the silicon substrate and having an impurity concentration higher than that in the silicon substrate, and the anti-reflection film being a titanium oxide film containing an impurity identical in conductivity type to the silicon substrate.

Preferably, in the back electrode type solar cell according to the present invention, the impurity contained in the anti-reflection film is an n-type impurity, and the n-type impurity is present as phosphorus oxide in an amount of not less than 15% and not more than 35% by mass of the anti-reflection film.

Furthermore, the present invention is directed to a back electrode type solar cell module in which a plurality of any of the above-described back electrode type solar cells are disposed, including a sealing resin and a transparent substrate in this order on a light-receiving surface-side of the back electrode type solar cells.

In the back electrode type solar cell module according to the present invention, the sealing resin preferably contains at least one selected from the group consisting of ethylene vinyl acetate, a silicone resin, and a polyolefin resin.

### ADVANTAGEOUS EFFECTS OF INVENTION

According to the present invention, a method for producing a back electrode type solar cell that allows efficient production with a reduced number of steps, a back electrode type solar cell, and a back electrode type solar cell module can be provided.

### BRIEF DESCRIPTION OF DRAWINGS

Fig. 1 is a schematic plan view of a back surface of a back electrode type solar cell according to a first embodiment.
Fig. 2 (a) is a schematic cross-sectional view along line II-II in Fig. 1, and Fig. 2(b) is a schematic enlarged cross-sectional view of a portion of a light-receiving surface of an n-type silicon substrate shown in Fig. 2 (a).
Figs. 3(a) to (k) are schematic cross-sectional views for illustrating an exemplary method for producing the back electrode type solar cell according to the first embodiment.
Fig. 4 (a) is a schematic cross-sectional view of a back electrode type solar cell according to a second embodiment, and Fig. 4 (b) is a schematic enlarged cross-sectional view of a portion of a light-receiving surface of an n-type silicon substrate shown in Fig. 4 (a).
Figs. 5(a) to (i) are schematic cross-sectional views for illustrating an exemplary method for producing the back electrode type solar cell according to the second embodiment.
Fig. 6 is a diagram showing the relationship between surface reflectance of the back electrode type solar cell according to the first embodiment and surface reflectance of the back electrode type solar cell according to a first comparative example.
Fig. 7 (a) is a schematic cross-sectional view of a back electrode type solar cell module according to the first embodiment, and Fig. 7 (b) is a schematic cross-sectional view of a back electrode type solar cell module according to the first comparative example.
Fig. 8 is a diagram showing the relationship between surface reflectance of the back electrode type solar cell module according to the first embodiment and surface reflectance of the back electrode type solar cell module according to the first comparative example.
Fig. 9 is a schematic cross-sectional view of the conventional back electrode type solar cell disclosed in PTL 1.

### DESCRIPTION OF EMBODIMENTS

Embodiments of the present invention will be described hereinafter. In the drawings of the present invention, the same or corresponding elements are denoted by the same reference characters.

### <First Embodiment>

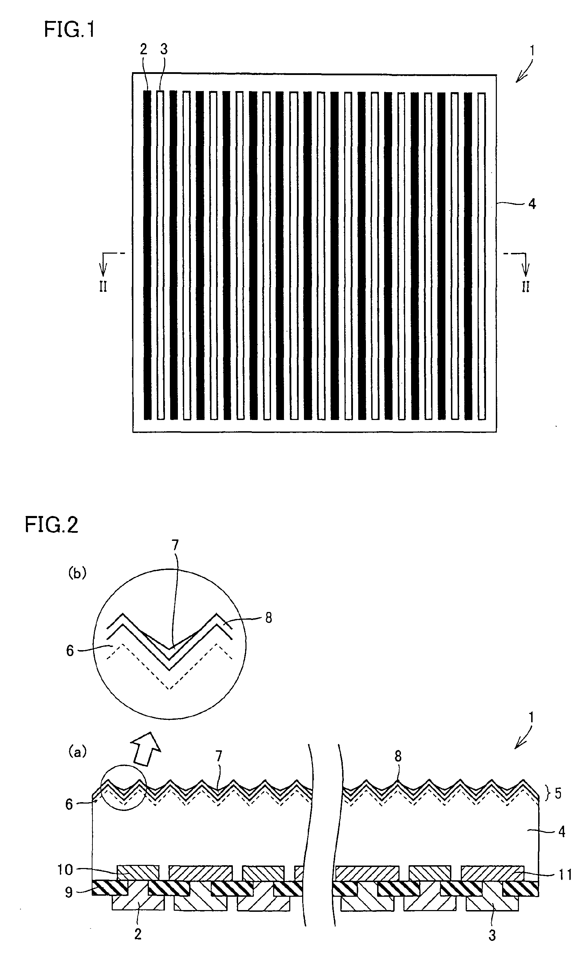

Fig. 1 shows a schematic plan view of a back surface of a back electrode type solar cell according to a first embodiment. Back electrode type solar cell 1 shown in Fig. 1 includes a band-shaped n-type electrode 2 and a band-shaped p-type electrode 3 on a back surface opposite to a light-receiving surface of an n-type silicon substrate 4, and n-type electrode 2 and p-type electrode 3 are arranged alternately on the back surface of n-type silicon substrate 4.

Fig. 2 (a) is a schematic cross-sectional view along line II-II in Fig. 1, and Fig. 2(b) is a schematic enlarged cross-sectional view of a portion of the light-receiving surface of n-type silicon substrate 4 shown in Fig. 2 (a). As shown in Fig. 2 (a), a concavo-convex shape 5 is formed on the light-receiving surface of n-type silicon substrate 4.

An n⁺ layer 6 is formed as a light-receiving surface diffusion layer, which serves as an FSF layer, on the light-receiving surface of n-type silicon substrate 4. N⁺ layer 6 has n-type conductivity identical to that of n-type silicon substrate 4, and has an n-type impurity concentration higher than that in n-type silicon substrate 4.

As shown in Fig. 2 (b), a light-receiving surface passivation film 8 is formed on n⁺ layer 6. Light-receiving surface passivation film 8 is made of a silicon oxide film. The thickness of light-receiving surface passivation film 8 is preferably not less than 30 nm and not more than 200 nm. When the thickness of light-receiving surface passivation film 8 is not less than 30 nm and not more than 200 nm, characteristics of back electrode type solar cell 1 tend to improve.

As shown in Fig. 2 (b), an anti-reflection film 7 is formed on light-receiving surface passivation film 8. Anti-reflection film 7 contains an n-type impurity having n-type conductivity identical to that of n-type silicon substrate 4, and is made of, for example, a titanium oxide film containing phosphorus as the n-type impurity. The thickness of anti-reflection film 7 may be not less than 0 nm and not more than 500 nm, for example. A section where the thickness of anti-reflection film 7 is 0 nm means a section where a portion of anti-reflection film 7 is not formed.

The phosphorus in anti-reflection film 7 is preferably present as phosphorus oxide in an amount of not less than 15% and not more than 35% by mass of anti-reflection film 7. The expression that the phosphorus is present as phosphorus oxide in an amount of not less than 15% and not more than 35% by mass of anti-reflection film 7 means that the amount of phosphorus oxide contained in anti-reflection film 7 is not less than 15% and not more than 35% by mass of the entire anti-reflection film 7.

As shown in Fig. 2 (a), an n⁺⁺ layer 10 serving as an n-type impurity diffusion layer and a p⁺ layer 11 serving as a p-type impurity diffusion layer are formed alternately on the back surface of n-type silicon substrate 4. Moreover, a back surface passivation film 9, which is made of a silicon oxide film, is formed on a portion of the back surface of n-type silicon substrate 4. An n-type electrode 2 and a p-type electrode 3 are formed on n⁺⁺ layer 10 and p⁺ layer 11, respectively, that are exposed through back surface passivation film 9.

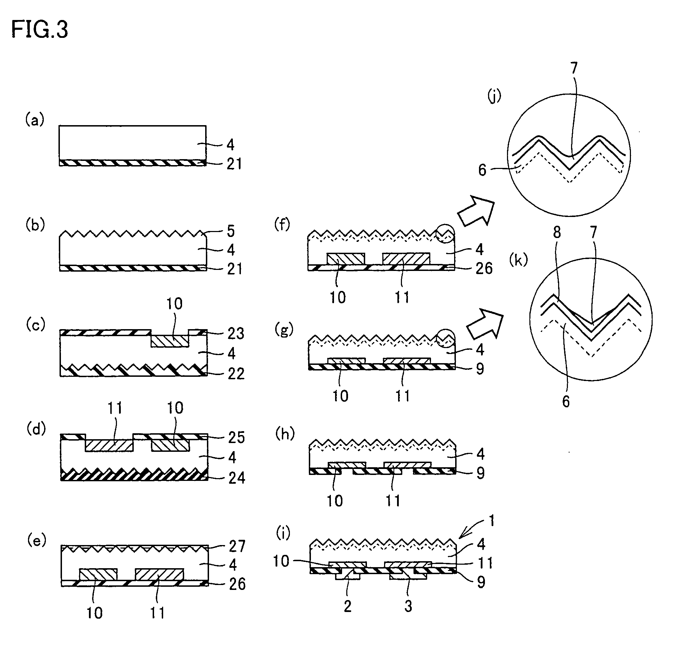

Referring to the schematic cross-sectional views in Figs. 3(a) to (k), an exemplary method for producing the back electrode type solar cell according to the first embodiment will be described hereinafter.

Initially, as shown in Fig. 3 (a), a texturing mask 21 is formed on the back surface of n-type silicon substrate 4. A silicon nitride film, for example, can be used here as texturing mask 21. Texturing mask 21 can be formed by CVD (Chemical Vapor Deposition) or sputtering, for example.

Next, as shown in Fig. 3 (b), concavo-convex shape 5 is formed on the light-receiving surface of n-type silicon substrate 4. Concavo-convex shape 5 may be a textured structure, for example. Concavo-convex shape 5 can be formed by, for example, etching the light-receiving surface of n-type silicon substrate 4 with a solution obtained by adding isopropyl alcohol to an alkaline aqueous solution, such as an aqueous solution of sodium hydroxide or an aqueous solution of potassium hydroxide, and heating the mixture to not lower than 70°C and not higher than 80°C.

Next, as shown in Fig. 3 (c), n⁺⁺ layer 10 is formed on a portion of the back surface of n-type silicon substrate 4. Here, n⁺⁺ layer 10 can be formed as follows, by way of example.

Initially, texturing mask 21 on the back surface of n-type silicon substrate 4 is removed. A diffusion mask 22, for example, a silicon oxide film, is next formed on the light-receiving surface of n-type silicon substrate 4. A diffusion mask 23 is next formed by applying a masking paste to a region of the back surface of n-type silicon substrate 4 except for the region where n⁺⁺ layer 10 is formed, and then heat-treating the masking paste. Then, phosphorus is diffused into a section where the back surface of n-type silicon substrate 4 is exposed through diffusion mask 23 by vapor phase diffusion using POCl₃, thereby forming n⁺⁺ layer 10.

A masking paste containing a solvent, a thickener, and a silicon oxide precursor, for example, may be used as the masking paste. Ink jet printing or screen printing, for example, may be used as the method of applying the masking paste.

Next, as shown in Fig. 3 (d), a p⁺ layer 11 is formed on a portion of the back surface of n-type silicon substrate 4. Here, p⁺ layer 11 can be formed as follows, by way of example.

Initially, diffusion mask 22 and diffusion mask 23 formed on the light-receiving surface and the back surface, respectively, of n-type silicon substrate 4, and a glass layer formed by diffusion of phosphorus into diffusion masks 22, 23 are removed by etching with fluoric acid, for example. A diffusion mask 24, for example, a silicon oxide film, is next formed on the light-receiving surface of n-type silicon substrate 4. A diffusion mask 25 is next formed by applying a masking paste to a region of the back surface of n-type silicon substrate 4 except for the region where p⁺ layer 11 is formed, and then heat-treating the masking paste. Then, p⁺ layer 11 is formed by diffusing boron into a section where the back surface of n-type silicon substrate 4 is exposed through diffusion mask 25, by applying to the back surface of n-type silicon substrate 4 a solution obtained by dissolving a polymer formed by reacting an organic polymer with a boron compound in an aqueous solution of an alcohol, and drying the solution, followed by heat treatment.

Next, as shown in Fig. 3 (e), a solution 27 is applied to the light-receiving surface of n-type silicon substrate 4 and then dried. Here, solution 27 can be applied and dried as follows, by way of example.

Initially, diffusion mask 24 and diffusion mask 25 formed on the light-receiving surface and the back surface, respectively, of n-type silicon substrate 4, and a glass layer formed by diffusion of a p-type impurity such as boron into diffusion masks 24, 25 are removed by etching with fluoric acid, for example. A diffusion mask 26, for example, a silicon oxide film, is next formed on the back surface of n-type silicon substrate 4. Then, solution 27 containing a phosphorus-containing compound, a titanium alkoxide, and an alcohol is applied to the light-receiving surface of n-type silicon substrate 4 by spin coating, for example, and then dried. Phosphorus pentoxide, for example, can be used here as the phosphorus-containing compound contained in solution 27. Tetraisopropyl titanate, for example, can be used as titanium alkoxide. Isopropyl alcohol, for example, can be used as the alcohol.

Next, as shown in Figs. 3 (f) and (j), n⁺ layer 6 and anti-reflection film 7 are formed on the light-receiving surface of n-type silicon substrate 4. Here, n⁺ layer 6 and anti-reflection film 7 can be formed by heat-treating n-type silicon substrate 4 in which solution 27 has been applied to the light-receiving surface, at a temperature not lower than 850°C and not higher than 1000°C. As a result of this heating, phosphorus is diffused from solution 27 into the light-receiving surface of n-type silicon substrate 4, whereby n⁺ layer 6 is formed, and anti-reflection film 7 made of the titanium oxide film containing phosphorus is also formed.

Here, the sheet resistance of n⁺ layer 6 is preferably not less than 30 Ω/□ and not more than 100 Ω/□, and more desirably, not less than 40 Ω/□ and not more than 60 Ω/□.

Next, as shown in Figs. 3 (g) and (k), light-receiving surface passivation film 8 is formed on the light-receiving surface of n-type silicon substrate 4. Here, light-receiving surface passivation film 8 can be formed as follows, by way of example.

Initially, diffusion mask 26 on the back surface of n-type silicon substrate 4 is removed by etching with fluoric acid. At this time, a portion of anti-reflection film 7 is also etched with fluoric acid, so that a portion of the light-receiving surface of n-type silicon substrate 4 becomes exposed. Since anti-reflection film 7 is made of the titanium oxide film containing phosphorus, it has high resistance to fluoric acid. Therefore, as shown in Fig. 3 (k), only the convex portion of concavo-convex shape 5 of the light-receiving surface of n-type silicon substrate 4 where anti-reflection film 7 is thin becomes exposed.

Next, thermal oxidation of n-type silicon substrate 4 with oxygen or water vapor is performed. As a result, back surface passivation film 9 made of a silicon oxide film is formed on the back surface of n-type silicon substrate 4, and light-receiving surface passivation film 8 made of a silicon oxide film is also formed on the light-receiving surface of n-type silicon substrate 4. At this time, as shown in Fig. 3 (k), light-receiving surface passivation film 8 is formed on the convex portion of concavo-convex shape 5 of the light-receiving surface where n-type silicon substrate 4 is exposed, and is also formed between n⁺ layer 6 of the light-receiving surface of n-type silicon substrate 4 and anti-reflection film 7. The reason why light-receiving surface passivation film 8 is formed between n⁺ layer 6 and anti-reflection film 7 is believed to be that anti-reflection film 7 develops a crack due to an increased thickness of anti-reflection film 7 on the concave portion of concavo-convex shape 5 of the light-receiving surface, and oxygen or water vapor enters through the section where the crack is formed, whereby the silicon oxide film, that is, light-receiving surface passivation film 8, is grown. The thickness of light-receiving surface passivation film 8 is not less than 100 nm and not more than 200 nm, for example, the thickness of back surface passivation film 9 on n⁺⁺ layer 10 is not less than 30 nm and not more than 100 nm, for example, and the thickness of back surface passivation film 9 on p⁺ layer 11 is 10 nm not more than 40 nm, for example.

Here, the thermal oxidation of n-type silicon substrate 4 with oxygen or water vapor can be carried out by performing heat treatment with n-type silicon substrate 4 being placed in an oxygen atmosphere or a water vapor atmosphere.

Next, as shown in Fig. 3 (h), portions of back surface passivation film 9 are removed, so that a portion of n⁺⁺ layer 10 and a portion of p⁺ layer 11 become exposed through back surface passivation film 9. Here, the portions of back surface passivation film 9 can be removed by, for example, applying an etching paste to the portions of back surface passivation film 9 by screen printing or the like, and then heating the etching paste. The etching paste can then be removed by, for example, performing acid treatment following ultrasonic cleaning. An etching paste containing at least one selected from the group consisting of phosphoric acid, hydrogen fluoride, ammonium fluoride, and ammonium hydrogen fluoride as an etching component, and also containing water, an organic solvent, and a thickener, can be used, for example, as the etching paste.

Next, as shown in Fig. 3 (i), n-type electrode 2 is formed on n⁺⁺ layer 10, and p-type electrode 3 is formed on p⁺ layer 11. Here, each of n-type electrode 2 and p-type electrode 2 can be formed by, for example, applying a silver paste to a predetermined position of back surface passivation film 9 on the back surface of n-type silicon substrate 4 by screen printing, and then drying, followed by firing the silver paste. As a result, back electrode type solar cell 1 according to the first embodiment can be produced.

In the method for producing back electrode type solar cell 1 according to the first embodiment, n⁺ layer 6 serving as the light-receiving surface diffusion layer and anti-reflection film 7 can be formed simultaneously (formed in a single step), and light-receiving surface passivation film 8 and back surface passivation film 9 can also be formed simultaneously (formed in a single step). Thus, back electrode type solar cell 1 can be produced efficiently with a reduced number of steps.

### <Second Embodiment>

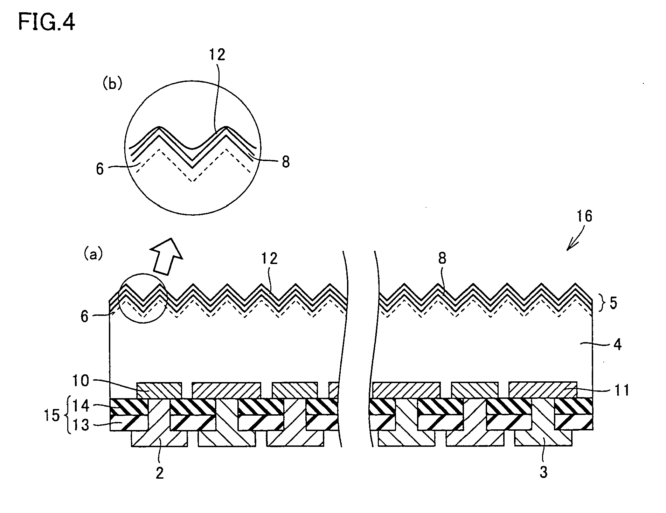

Fig. 4 (a) shows a schematic cross-sectional view of a back electrode type solar cell according to a second embodiment, and Fig. 4 (b) is a schematic enlarged cross-sectional view of a portion of a light-receiving surface of n-type silicon substrate 4 shown in Fig. 4 (a). As shown in Fig. 4 (a), a concavo-convex shape 5 is formed on the light-receiving surface of n-type silicon substrate 4.

Back electrode type solar cell 16 according to the second embodiment has a feature in that an anti-reflection film 12 is formed over the entire light-receiving surface of n-type silicon substrate 4, and a back surface passivation film 15 including a second back surface passivation film 14 and a first back surface passivation film 13 layered in this order from n-type silicon substrate 4 is formed on the back surface of n-type silicon substrate 4.

Light-receiving surface passivation film 8 is made of a silicon oxide film. The thickness of light-receiving surface passivation film 8 is preferably not less than 30 nm and not more than 200 nm. When the thickness of light-receiving surface passivation film 8 is not less than 30 nm and not more than 200 nm, characteristics of back electrode type solar cell 16 tend to improve.

Anti-reflection film 12 contains an n-type impurity having n-type conductivity identical to that of n-type silicon substrate 4, and is made of, for example, a titanium oxide film containing phosphorus as an n-type impurity. The thickness of anti-reflection film 12 may be not less than 30 nm and not more than 500 nm, for example.

The phosphorus in anti-reflection film 12 is preferably present as phosphorus oxide in an amount of not less than 15% and not more than 35% by mass of anti-reflection film 12.

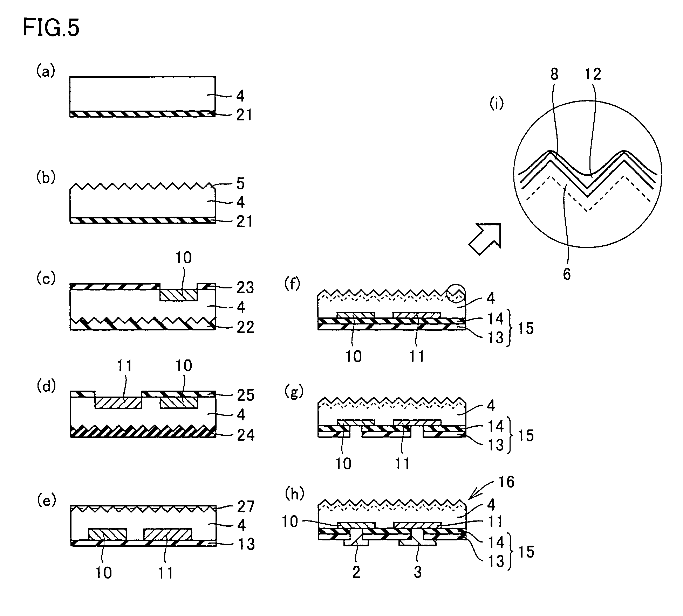

Referring to the schematic cross-sectional views in Figs. 5(a) to (i), an exemplary method for producing the back electrode type solar cell according to the second embodiment will be described hereinafter.

Initially, as shown in Fig. 5 (a), texturing mask 21 is formed on the back surface of n-type silicon substrate 4, and then concavo-convex shape 5 is formed on the light-receiving surface of n-type silicon substrate 4, as shown in Fig. 5 (b).

Next, as shown in Fig. 5 (c), texturing mask 21 on the back surface of n-type silicon substrate 4 is removed, and then diffusion mask 22 is formed on the light-receiving surface of n-type silicon substrate 4 and diffusion mask 23 is formed on a portion of the back surface of n-type silicon substrate 4, and subsequently, n⁺⁺ layer 10 is formed on the portion of the back surface of n-type silicon substrate 4.

Next, as shown in Fig. 5 (d), each of diffusion mask 22 on the light-receiving surface and diffusion mask 23 on the back surface of n-type silicon substrate 4 is removed, and then diffusion mask 24 is formed on the light-receiving surface of n-type silicon substrate 4 and diffusion mask 25 is formed on a portion of the back surface of n-type silicon substrate 4, and subsequently, p⁺ layer 11 is formed on the portion of the back surface of n-type silicon substrate 4.

Next, as shown in Fig. 5 (e), a solution 27 is applied to the light-receiving surface of n-type silicon substrate 4 and then dried. Here, solution 27 can be applied and dried as follows, by way of example.

Initially, diffusion mask 24 and diffusion mask 25 formed on the light-receiving surface and the back surface, respectively, of n-type silicon substrate 4, and a glass layer formed by diffusion of a p-type impurity such as boron into diffusion masks 24, 25 are removed by etching with fluoric acid, for example. Next, first back surface passivation film 13 also serving as a diffusion mask, which is made of a silicon oxide film or the like having a thickness of not less than 50 nm and not more than 100 nm, for example, is formed on the back surface of n-type silicon substrate 4. First back surface passivation film 13 can be formed by CVD, or by applying and firing SOG (spin on glass), for example. Then, solution 27 containing a phosphorus-containing compound, a titanium alkoxide, and an alcohol is applied to the light-receiving surface of n-type silicon substrate 4 by spin coating, for example, and then dried. Phosphorus pentoxide, for example, can be used here as the phosphorus-containing compound contained in solution 27. Tetraisopropyl titanate, for example, can be used as the titanium alkoxide. Isopropyl alcohol, for example, can be used as the alcohol.

Next, as shown in Figs. 5 (f) and (i), n⁺ layer 6, light-receiving surface passivation film 8, and anti-reflection film 12 are formed on the light-receiving surface of n-type silicon substrate 4, and second back surface passivation film 14 is also formed between the back surface of n-type silicon substrate 4 and first back surface passivation film 13.

Here, n⁺ layer 6 and anti-reflection film 12 can be formed by heat-treating n-type silicon substrate 4 in which solution 27 has been applied to the light-receiving surface, at a temperature not lower than 850°C and not higher than 1000°C. As a result of this heating, phosphorus is diffused from solution 27 into the light-receiving surface of n-type silicon substrate 4, whereby n⁺ layer 6 is formed, and anti-reflection film 12 made of the titanium oxide film containing phosphorus is also formed.

The sheet resistance of n⁺ layer 6 is preferably not less than 30 Ω/□ and not more than 100 Ω/□, and more desirably, not less than 40 Ω/□ and not more than 60 Ω/□.

Light-receiving surface passivation film 8 and second back surface passivation film 14 can be formed by thermal oxidation of n-type silicon substrate 4 with oxygen or water vapor, after the formation of n⁺ layer 6 and anti-reflection film 12. As a result, as shown in Fig. 5 (i), light-receiving surface passivation film 8 is formed between n⁺ layer 6 on the light-receiving surface of n-type silicon substrate 4 and anti-reflection film 12, and second back surface passivation film 14 is also formed between the back surface of n-type silicon substrate 4 and first back surface passivation film 13. This layered structure of first back surface passivation film 13 and second back surface passivation film 14 is denoted as back surface passivation film 15. The reason why light-receiving surface passivation film 8 is formed between n⁺ layer 6 and anti-reflection film 12 is believed to be that anti-reflection film 12 develops a crack due to an increased thickness of anti-reflection film 12 on the concave portion of concavo-convex shape 5 of the light-receiving surface, and oxygen or water vapor enters through the section where the crack is formed, whereby the silicon oxide film, that is, light-receiving surface passivation film 8, is grown. It is also believed that because the thickness of anti-reflection film 12 is thin on the convex portion of concavo-convex shape 5 of the light-receiving surface, oxygen or water vapor permeates therethrough, whereby the silicon oxide film, that is, light-receiving surface passivation film 8, is grown. Furthermore, the reason why second back surface passivation film 14 is formed between the back surface of n-type silicon substrate 4 and first back surface passivation film 13 is believed to be that because first back surface passivation film 13 on the back surface of n-type silicon substrate 4 is a film formed by CVD or the like, oxygen or water vapor permeates into first back surface passivation film 13, whereby the silicon oxide film, that is, second back surface passivation film 14, is grown. The thickness of light-receiving surface passivation film 8 is not less than 100 nm and not more than 200 nm, for example, the thickness of second back surface passivation film 14 on n⁺⁺ layer 10 is not less than 30 nm and not more than 100 nm, for example, and the thickness of second back surface passivation film 14 on p⁺ layer 11 is not less than 10 nm not more than 40 nm, for example.

Here, the thermal oxidation of n-type silicon substrate 4 with oxygen or water vapor for the formation of light-receiving surface passivation film 8 and second back surface passivation film 14 can be carried out by performing heat treatment with n-type silicon substrate 4 being placed in an oxygen atmosphere or a water vapor atmosphere.

Alternatively, light-receiving surface passivation film 8 and second back surface passivation film 14 can be formed subsequent to the heat treatment for forming n⁺ layer 6 and anti-reflection film 12, by performing thermal oxidation of n-type silicon substrate 4 with the atmospheric gas being switched to an oxygen atmosphere or a water vapor atmosphere.

Next, as shown in Fig. 5 (g), portions of back surface passivation film 15 are removed, so that a portion of n⁺⁺ layer 10 and a portion of p⁺ layer 11 become exposed through back surface passivation film 9.

Next, as shown in Fig. 5 (h), n-type electrode 2 is formed on n⁺⁺ layer 10, and p-type electrode 3 is formed on p⁺ layer 11. As a result, back electrode type solar cell 16 according to the second embodiment can be produced.

In the method for producing the back electrode type solar cell according to the second embodiment, n⁺ layer 6 serving as the light-receiving surface diffusion layer and anti-reflection film 12 can be formed simultaneously (formed in a single step), and light-receiving surface passivation film 8 and second back surface passivation film 14 can also be formed simultaneously (formed in a single step). Thus, back electrode type solar cell 16 can be produced efficiently with a reduced number of steps.

Furthermore, in back electrode type solar cell 16 according to the second embodiment, the entire light-receiving surface of n-type silicon substrate 4 is covered with anti-reflection film 12 made of the titanium oxide film having a high refractive index, and the convex portion of concavo-convex shape 5 of the light-receiving surface of n-type silicon substrate 4 is not exposed through anti-reflection film 12, as in back electrode type solar cell 1 according to the first embodiment. Thus, surface reflectance for incident sunlight can be reduced more than in back electrode type solar cell 1 according to the first embodiment.

### <Evaluation>

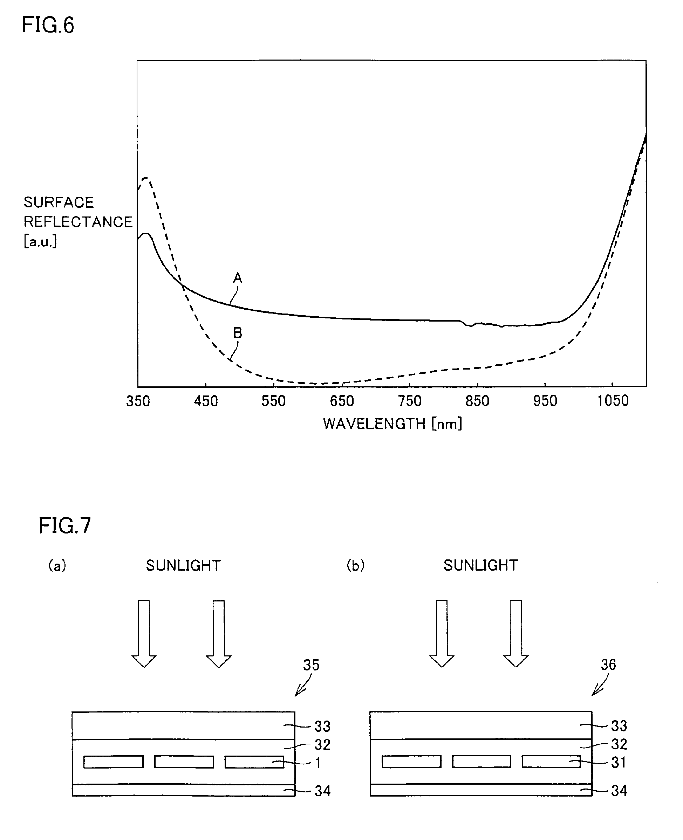

Each of the surface reflectance of back electrode type solar cell 1 according to the first embodiment and the surface reflectance of the back electrode type solar cell according to the first comparative example was evaluated. The results are shown in Fig. 6. Evaluation of surface reflectance was conducted here as follows: light with varying wavelengths was directed onto each of the light-receiving surface of back electrode type solar cell 1 according to the first embodiment and the light-receiving surface of the back electrode type solar cell according to the first comparative example, and reflectances were measured. The vertical axis in Fig. 6 represents surface reflectance (a.u.), and the horizontal axis in Fig. 6 represents wavelength (nm) of incident light. Curve A in Fig. 6 represents the surface reflectance of back electrode type solar cell 1 according to the first embodiment, and curve B in Fig. 6 represents the surface reflectance of the back electrode type solar cell according to the first comparative example.

In the back electrode type solar cell according to the first comparative example, an anti-reflection film made of a silicon nitride film was formed by plasma CVD.

As shown in Fig. 6, no significant dependence on the wavelength of incident light is observed for back electrode type solar cell 1 according to the first embodiment, however, wavelength dependence of surface reflectance in the visible light region (wavelengths of incident light: 400 nm to 750 nm) is clearly observed for the back electrode type solar cell according to the first comparative example. For this reason, a specific color due to an interference effect of incident color is observed on the light-receiving surface of the back electrode type solar cell according to the first comparative example. It is observed, on the other hand, that surface reflectance is lower in the back electrode type solar cell according to the first comparative example than in back electrode type solar cell 1 according to the first embodiment.

Next, a back electrode type solar cell module was made with each of back electrode type solar cell 1 according to the first embodiment and the back electrode type solar cell according to the first comparative example. Fig. 7 (a) shows a schematic cross-sectional view of the back electrode type solar cell module in which a plurality of back electrode type solar cells 1 according to the first embodiment are electrically connected to one another (back electrode type solar cell module 35 according to the first embodiment). Fig. 7 (b) shows a schematic cross-sectional view of the back electrode type solar cell module in which a plurality of back electrode type solar cells 31 according to the first comparative example are electrically connected to one another (back electrode type solar cell module 36 according to the first comparative example).

As shown in Fig. 7 (a), back electrode type solar cell module 35 according to the first embodiment is fabricated by sealing the plurality of electrically connected back electrode type solar cells 1 according to the first embodiment in a sealing resin 32 made of EVA (Ethylene Vinyl Acetate) between a transparent substrate 33 made of a glass substrate, disposed on the light-receiving surface-side of back electrode type solar cells 1, and a back surface protective sheet 34 made of a polyester film, disposed on the back surface-side of back electrode type solar cells 1.

As shown in Fig. 7 (b), back electrode type solar cell module 36 according to the first comparative example 1 is similarly fabricated by sealing the plurality of electrically connected back electrode type solar cells 31 according to the first comparative example in sealing resin 32 made of EVA between transparent substrate 33 made of a glass substrate, disposed on the light-receiving surface-side of back electrode type solar cells 31 according to the first comparative example, and back surface protective sheet 34 made of a polyester film, disposed on the back surface-side of back electrode type solar cells 31 according to the first comparative example.

A resin containing at least one selected from the group consisting of ethylene vinyl acetate, a silicone resin, and a polyolefin resin, for example, can be used as sealing resin 32, with EVA being particularly preferably used.

Each of the surface reflectance of back electrode type solar cell module 35 according to the first embodiment and the surface reflectance of back electrode type solar cell module 36 according to the first comparative example fabricated as above was evaluated in the same manner as described above. The results are shown in Fig. 8. The vertical axis in Fig. 8 represents surface reflectance (a.u.), and the horizontal axis in Fig. 8 represents wavelength (nm) of incident light. Curve C in Fig. 8 represents the surface reflectance of back electrode type solar cell module 35 according to the first embodiment, and curve D in Fig. 8 represents the surface reflectance of back electrode type solar cell module 36 according to the first comparative example.

As shown in Fig. 8, the difference in surface reflectance between back electrode type solar cell module 35 according to the first embodiment and back electrode type solar cell module 36 according to the first comparative example was confirmed to be smaller than that shown in Fig. 6 between back electrode type solar cell 1 according to the first embodiment and back electrode type solar cell 31 according to the first comparative example.

Therefore, as shown in Fig. 8, it was confirmed that in the case of back electrode type solar cell module 35 using back electrode type solar cells 1 according to the first embodiment fabricated by the process with a smaller number of steps than that in the first comparative example, the difference in surface reflectance between back electrode type solar cell module 35 and back electrode type solar cell module 36 according to the first comparative example made with a greater number of steps can be reduced.

Furthermore, back electrode type solar cell module 35 according to the first embodiment is further improved in the amount of current owing to the reduced surface reflectance, by the amount of the area where an electrode is not provided on the light-receiving surface, as compared to a solar cell module in which a plurality of solar cells, each including electrodes on both of the light-receiving surface and the back surface, are electrically connected to one another.

While cases where the n-type silicon substrate is used have been described above, a p-type silicon substrate may be used instead of the n-type silicon substrate. When a p-type silicon substrate is used instead of the n-type silicon substrate, a p⁺ layer having a p-type impurity diffused therein is used as the light-receiving surface diffusion layer, and a titanium oxide film containing a p-type impurity is used as the anti-reflection film.

Moreover, the concept of the back electrode type solar cell according to one embodiment of the present invention includes not only a back electrode type solar cell in which both an n-type electrode and a p-type electrode are formed on one surface (back surface) of a semiconductor substrate, but also a solar cell having an MWT (Metal Wrap Through) type structure (a solar cell in which a portion of an electrode is disposed in a through-hole provided in a semiconductor substrate), etc.

It should be understood that the embodiments disclosed herein are illustrative and non-restrictive in every respect. The scope of the present invention is defined by the terms of the claims, rather than by the foregoing description, and is intended to include any modifications within the scope and meaning equivalent to the terms of the claims.

### INDUSTRIAL APPLICABILITY

One embodiment of the present invention can be generally and widely utilized in methods for producing back electrode type solar cells, back electrode type solar cells, and back electrode type solar cell modules.

### REFERENCE SIGNS LIST

1, 16, 31: back electrode type solar cell; 2: n-type electrode; 3: p-type electrode; 4: n-type silicon substrate; 5: concavo-convex shape; 6: n⁺ layer; 7, 12: anti-reflection film; 8: light-receiving surface passivation film; 9, 15: back surface passivation film; 10: n⁺⁺ layer; 11: p⁺ layer; 13: first back surface passivation film; 14: second back surface passivation film; 21: texturing mask; 22, 23, 24, 25, 26: diffusion mask; 27: solution; 32: sealing resin; 33: transparent substrate; 34: back surface protective sheet; 35, 36: back electrode type solar cell module; 101: back electrode type solar cell; 102: n-type metal contact; 103: p-type metal contact; 104: n-type silicon wafer; 105: concavo-convex shape; 106: front surface-side n-type diffusion region; 107: anti-reflection coating; 108: dielectric passivation layer; 109: oxide layer; 110: n⁺ region; 111: p⁺ region.

## Claims

1. A method for producing a back electrode type solar cell (1, 16) comprising the steps of:
forming a light-receiving surface diffusion layer (6) and an anti-reflection film (7, 12) by applying, to a light-receiving surface of a silicon substrate (4), a solution containing a compound containing an impurity identical in conductivity type to said silicon substrate (4), a titanium alkoxide, and an alcohol, followed by heat treatment;
forming a light-receiving surface passivation film (8) on said light-receiving surface of said silicon substrate (4) by heat treatment; and
forming an n-type electrode (2) and a p-type electrode (3) on a back surface of said silicon substrate (4) opposite to said light-receiving surface.

2. The method for producing the back electrode type solar cell (1, 16) according to claim 1, wherein
said light-receiving surface passivation film (8) is a silicon oxide film.

3. The method for producing the back electrode type solar cell (1, 16) according to claim 1 or 2, wherein
the step of forming said light-receiving surface passivation film (8) includes the step of forming a back surface passivation film (9, 15) on the back surface of said silicon substrate (4).

4. The method for producing the back electrode type solar cell (1, 16) according to any of claims 1 to 3, wherein
said light-receiving surface diffusion layer (6) has a sheet resistance of not less than 30 Ω/□ and not more than 100 Ω/□.

5. The method for producing the back electrode type solar cell (1, 16) according to any of claims 1 to 4, wherein
said light-receiving surface passivation film (8) has a thickness not less than 30 nm and not more than 200 nm.

6. A back electrode type solar cell (1, 16) comprising:
a light-receiving surface diffusion layer (6) provided on a light-receiving surface of a silicon substrate (4);
a light-receiving surface passivation film (8) provided on said light-receiving surface diffusion layer (6);
an anti-reflection film (7, 12) provided on said light-receiving surface passivation film (8); and
an n-type electrode (2) and a p-type electrode (3) provided on a back surface opposite to said light-receiving surface of said silicon substrate (4),
said light-receiving surface diffusion layer (6) being identical in conductivity type to said silicon substrate (4) and having an impurity concentration higher than that in said silicon substrate (4), and
said anti-reflection film (7, 12) being a titanium oxide film containing an impurity identical in conductivity type to said silicon substrate (4).

7. A back electrode type solar cell (1, 16) comprising:
a light-receiving surface diffusion layer (6) provided on a light-receiving surface of a silicon substrate (4);
a light-receiving surface passivation film (8) provided on said light-receiving surface diffusion layer (6);
an anti-reflection film (7, 12) provided on a portion of said light-receiving surface passivation film (8); and
an n-type electrode (2) and a p-type electrode (3) provided on a back surface opposite to said light-receiving surface of said silicon substrate (4),
said light-receiving surface diffusion layer (6) being identical in conductivity type to said silicon substrate (4) and having an impurity concentration higher than that in said silicon substrate (4), and
said anti-reflection film (7, 12) being a titanium oxide film containing an impurity identical in conductivity type to said silicon substrate (4).

8. The back electrode type solar cell (1, 16) according to claim 6 or 7, wherein
the impurity contained in said anti-reflection film (7, 12) is an n-type impurity, and
said n-type impurity is present as phosphorus oxide in an amount of not less than 15% and not more than 35% by mass of said anti-reflection film (7, 12).

9. A back electrode type solar cell module (35) in which a plurality of the back electrode type solar cells (1, 16) according to any of claims 6 to 8 are disposed, comprising:
a sealing resin (32) and a transparent substrate (33) in this order on a light-receiving surface-side of said back electrode type solar cells (1, 16).

10. The back electrode type solar cell module (35) according to claim 9, wherein
said sealing resin (32) contains at least one selected from the group consisting of ethylene vinyl acetate, a silicone resin, and a polyolefin resin.
